(19) Europäisches Patentamt / European Patent Office / Office européen des brevets

(11) **EP 3 807 629 B1**

(12) **FASCICULE DE BREVET EUROPEEN**

(45) Date de publication et mention de la délivrance du brevet:
**13.04.2022 Bulletin 2022/15**

(21) Numéro de dépôt: **19731677.1**

(22) Date de dépôt: **13.06.2019**

(51) Classification Internationale des Brevets (IPC):
***G01N 27/74*** *(2006.01)*

(52) Classification Coopérative des Brevets (CPC):
**G01N 27/745**

(86) Numéro de dépôt international:
**PCT/EP2019/065560**

(87) Numéro de publication internationale:
**WO 2019/238857 (19.12.2019 Gazette 2019/51)**

(54) **DISPOSITIF ET PROCEDE DE DETECTION MAGNETIQUE D'OBJETS BIOLOGIQUES MICROSCOPIQUES**

VORRICHTUNG UND VERFAHREN ZUM MAGNETISCHEN NACHWEIS VON MIKROSKOPISCHEN BIOLOGISCHEN OBJEKTEN

DEVICE AND METHOD FOR MAGNETIC DETECTION OF MICROSCOPIC BIOLOGICAL OBJECTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.06.2018 FR 1855217**

(43) Date de publication de la demande:
**21.04.2021 Bulletin 2021/16**

(73) Titulaire: **Commissariat à l'Energie Atomique et aux Energies Alternatives**
**75015 Paris (FR)**

(72) Inventeurs:
• **FERMON, Claude**
**91191 Gif-sur-Yvette (FR)**
• **GIRAUD, Manon**
**91191 Gif-sur-Yvette (FR)**
• **DELAPIERRE, Francois-Damien**
**91191 Gif-sur-Yvette (FR)**
• **JASMIN, Guenaelle**
**91191 Gif-sur-Yvette (FR)**

(74) Mandataire: **Cabinet Camus Lebkiri**
**25 rue de Maubeuge**
**75009 Paris (FR)**

(56) Documents cités:
**CN-B- 106 370 842     US-A1- 2014 295 460**

• **ZHU CHENG ET AL: "A micro-array bio detection system based on a GMR sensor with 50-ppm sensitivity", SCIENCE CHINA INFORMATION SCIENCES, SCIENCE CHINA PRESS, HEIDELBERG, vol. 60, no. 8, 24 avril 2017 (2017-04-24) , pages 1-9, XP036227520, ISSN: 1674-733X, DOI: 10.1007/S11432-016-0645-2 [extrait le 2017-04-24]**
• **KOKKINIS G ET AL: "Magnetic-based biomolecule detection using giant magnetoresistance sensors", JOURNAL OF APPLIED PHYSICS, AMERICAN INSTITUTE OF PHYSICS, US, vol. 117, no. 17, 7 mai 2015 (2015-05-07), XP012196407, ISSN: 0021-8979, DOI: 10.1063/1.4917244 [extrait le 1901-01-01]**

EP 3 807 629 B1

**Description**

## DOMAINE TECHNIQUE DE L'INVENTION

Le domaine de l'invention est celui de la détection de petits objets biologiques.

L'invention se rapporte plus particulièrement à un dispositif de détection magnétique d'objets biologiques microscopiques, tels des cellules, des bactéries ou des protéines.

## ETAT DE LA TECHNIQUE ANTERIEURE

Dans le domaine de la détection d'objets biologiques microscopiques, la cytométrie en flux est une technique connue selon laquelle des particules à détecter sont mises en solution dans un fluide et circulent dans un canal fluidique passant dans le faisceau d'un laser. En passant dans ce faisceau, les particules absorbent puis réémettent de la lumière : c'est cette lumière réémise qui permet de les détecter. La cytométrie en flux requiert toutefois une instrumentation complexe.

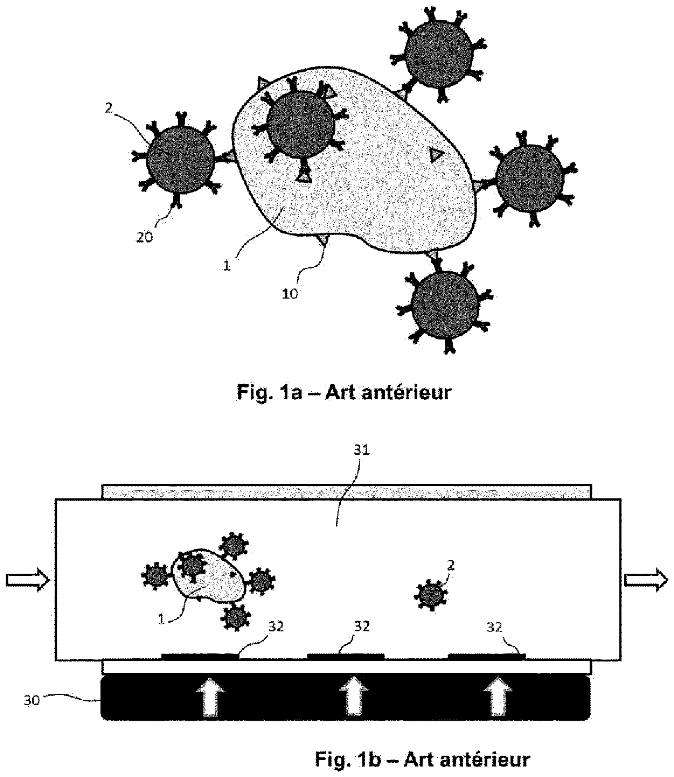

De nombreuses recherches s'orientent vers une technique de détection magnétique et non plus optique. Pour ce faire, ainsi qu'illustré aux figures 1a et 1b, des nanoparticules magnétiques 2 sont fixées aux objets 1 à détecter afin de servir de marqueurs et les objets 1 ainsi marqués sont détectés par des capteurs magnétiques 32. Pour que les nanoparticules magnétiques 2 puissent se fixer aux objets 1 à détecter, elles sont généralement elles-mêmes marquées avec des anticorps 20 spécifiques aptes à s'accrocher sur des récepteurs 10 des objets 1 à détecter. Plus un objet 1 à détecter est de grande taille, plus il peut accueillir de récepteurs 10 sur lesquels viennent se fixer des nanoparticules magnétiques 2 et donc plus son moment magnétique est susceptible d'être grand. Les objets 1 à détecter ainsi marqués sont ensuite mis en circulation dans un canal microfluidique 31 sous lequel sont agencés un aimant permanent 30 et les capteurs magnétiques 32.

A ce jour, cette approche de détection magnétique a été appliquée avec succès à la détection de cellules mais elle s'est avérée très difficile pour la détection de bactéries et infructueuse pour la détection de protéines.

Il est donc recherché une solution permettant de détecter des objets biologiques microscopiques, y compris des bactéries et des protéines, par une technique de détection magnétique et non optique.

## EXPOSE DE L'INVENTION

Dans ce contexte, un aspect de l'invention concerne un dispositif de détection magnétique d'objets biologiques microscopiques comportant :

- un canal microfluidique s'étendant une première extrémité amont et une deuxième extrémité aval, le canal microfluidique présentant une arrivée adaptée pour un fluide du côté de sa première extrémité amont et une sortie adaptée pour un fluide du côté de sa deuxième extrémité aval, le canal microfluidique ayant une longueur dans une première direction d'écoulement, une largeur dans deuxième direction perpendiculaire à la première direction et une hauteur dans une troisième direction perpendiculaire aux première et deuxième directions ;
- une pluralité de capteurs magnétiques agencés contre une paroi interne du canal microfluidique ; et
- un aimant permanent agencé contre une paroi externe du canal microfluidique, de manière que la pluralité de capteurs magnétiques soit plongée dans un champ magnétique créé par l'aimant permanent ;

la pluralité de capteurs magnétiques comportant :

- un premier capteur magnétique ;
- un deuxième capteur magnétique en vis-à-vis du premier capteur magnétique de manière que les premier et deuxième capteurs magnétiques soient alignés parallèlement à la troisième direction ;
- un troisième capteur magnétique agencé de manière que les premier et troisième capteurs magnétiques soient alignés parallèlement à la première direction et/ou un quatrième capteur magnétique agencé de manière que les deuxième et quatrième capteurs magnétiques soient alignés parallèlement à la première direction ; les troisième et quatrième capteurs magnétiques étant agencés en aval des premier et deuxième capteurs magnétiques ;
- un système de traitement de données configuré pour déterminer une vitesse d'un objet détecté à partir du temps écoulé entre deux détections d'un évènement pertinent par deux capteurs alignés parallèlement à la première direction et pour déterminer une hauteur d'un objet détecté à partir du rapport des signaux émis par au moins un couple de capteurs en vis-à-vis.

Les premier et deuxième capteurs magnétiques agencés de part et d'autre du canal microfluidique permettent de savoir, par un rapport de leurs mesures et indépendamment de toute connaissance ou hypothèse sur le moment magnétique de l'objet détecté, à quelle hauteur de canal se trouve chaque objet détecté afin de distinguer le signal d'un petit objet proche de celui d'un grand objet éloigné. Les troisième et/ou quatrième capteurs magnétiques en aval des premier et deuxième capteurs magnétiques permettent de déterminer la vitesse d'écoulement de l'objet détecté.

Outre les caractéristiques principales qui viennent d'être mentionnées, le dispositif de détection magnétique d'objets biologiques microscopiques selon un aspect de l'invention peut présenter une ou plusieurs caractéristiques complémentaires parmi les suivantes, considérées individuellement ou selon les combinaisons techniquement possibles :

- Le champ magnétique est colinéaire à la troisième direction. Un champ colinéaire à la troisième direction permet d'éviter que le champ soit planaire, c'est-à-dire que les lignes de champs soient colinéaires à la première direction, ce qui aurait pour conséquence de saturer les capteurs, ou que les lignes de champ soient colinéaires à la deuxième direction, ce qui réduirait la sensibilité des capteurs. Préférentiellement, la composante du champ magnétique selon la première direction et la composante du champ magnétique selon la deuxième direction ont des valeurs inférieures à 1 millitesla.

- La pluralité de capteurs magnétiques comporte le troisième capteur magnétique et le quatrième capteur magnétique, les troisième et quatrième capteurs magnétiques étant alignés parallèlement à la troisième direction.

- La pluralité de capteurs magnétiques comporte un cinquième capteur magnétique agencé de manière que les premier et cinquième capteurs magnétiques soient alignés parallèlement à la première direction et/ou un sixième capteur magnétique agencé de manière que les deuxième et sixième capteurs magnétiques soient alignés parallèlement à la première direction ; les cinquième et sixième capteurs magnétiques étant agencés en aval des troisième et quatrième capteurs magnétiques.

- La pluralité de capteurs magnétiques comporte le cinquième capteur magnétique et le sixième capteur magnétique, les cinquième et sixième capteurs magnétiques étant alignés parallèlement à la troisième direction.

- La pluralité de capteurs magnétiques comporte :

  ◦ un septième capteur magnétique agencé de manière que les premier et septième capteurs magnétiques soient alignés parallèlement à la deuxième direction, et
  ◦ un huitième capteur magnétique agencé de manière que les deuxième et huitième capteurs magnétiques soient alignés parallèlement à la deuxième direction et que les septième et huitième capteurs magnétiques soient alignés parallèlement à la troisième direction.

- La pluralité de capteurs magnétiques comporte :

  ◦ un neuvième capteur magnétique agencé de manière que les premier, septième et neuvième capteurs magnétiques soient alignés, et
  ◦ un dixième capteur magnétique agencé de manière que les deuxième, huitième et dixième capteurs magnétiques soient alignés et que les neuvième et dixième capteurs magnétiques soient alignés parallèlement à la troisième direction.

- La pluralité de capteurs magnétiques comporte :

  ◦ un onzième capteur magnétique agencé de manière que les troisième et onzième capteurs magnétiques soient alignés parallèlement à la deuxième direction, et
  ◦ un douzième capteur magnétique agencé de manière que les quatrième et douzième capteurs magnétiques soient alignés parallèlement à la deuxième direction et que les onzième et douzième capteurs magnétiques soient alignés parallèlement à la troisième direction.

- La pluralité de capteurs magnétiques comporte :

  ◦ un treizième capteur magnétique agencé de manière que les troisième, onzième et treizième capteurs magnétiques soient alignés, et
  ◦ un quatorzième capteur magnétique agencé de manière que les quatrième, douzième et quatorzième capteurs magnétiques soient alignés et que les treizième et quatorzième capteurs magnétiques soient alignés parallèlement à la troisième direction.

- La pluralité de capteurs magnétiques comporte :

  ◦ un quinzième capteur magnétique agencé de manière que les cinquième et quinzième capteurs magnétiques soient alignés parallèlement à la deuxième direction, et
  ◦ un seizième capteur magnétique agencé de manière que les sixième et seizième capteurs magnétiques soient alignés parallèlement à la deuxième direction et que les quinzième et seizième capteurs magnétiques soient alignés parallèlement à la troisième direction.

- La pluralité de capteurs magnétiques comporte :

  ◦ un dix-septième capteur magnétique agencé de manière que les cinquième, quinzième et dix-septième capteurs magnétiques soient alignés, et
  ◦ un dix-huitième capteur magnétique agencé de manière que les sixième, seizième et dix-huitième capteurs magnétiques soient alignés et que les dix-septième et dix-huitième capteurs magnétiques soient alignés parallèlement à la troisième direction.

Un autre aspect de l'invention concerne un procédé de détection magnétique d'objets biologiques microscopiques au moyen d'un dispositif selon le premier aspect de l'invention, le procédé comportant les étapes suivantes :

- détection d'un évènement par un capteur magnétique donné lorsque ledit capteur magnétique réalise une mesure supérieure à un seuil prédéterminé ;
- détection d'un évènement pertinent lorsqu'au moins deux capteurs espacés l'un de l'autre selon la première direction détectent chacun un évènement dans une fenêtre temporelle prédéterminée ;
- détection d'un objet biologique lorsqu'au moins deux capteurs alignés l'un avec l'autre selon la troisième direction détectent chacun simultanément un événement.

**BREVE DESCRIPTION DES FIGURES**

D'autres caractéristiques et avantages de l'invention ressortiront à la lecture de la description qui suit, en référence aux figures annexées.

- La figure 1a montre schématiquement des objets à détecter comportant des récepteurs et des nanoparticules magnétiques marquées par des anticorps spécifiques des récepteurs de manière que les nanoparticules magnétiques se fixent sur les objets à détecter.
- La figure 1b montre schématiquement une vue de côté d'un dispositif de détection magnétique d'objets biologiques selon l'art antérieur.
- La figure 2 montre schématiquement un dispositif de détection magnétique d'objets biologiques selon un premier mode de réalisation de l'invention.
- La figure 3 montre schématiquement une vue de côté d'un dispositif de détection magnétique d'objets biologiques selon un deuxième mode de réalisation de l'invention.
- La figure 4a montre schématiquement une vue de dessus d'un dispositif de détection magnétique d'objets biologiques selon une première variante d'un mode de réalisation de l'invention.
- La figure 4b montre schématiquement un dispositif de détection magnétique selon une deuxième variante d'un mode de réalisation de l'invention.
- La figure 5a montre schématiquement des signaux émis par deux capteurs magnétiques en vis-à-vis d'un dispositif de détection magnétique selon un mode de réalisation de l'invention, dans le cas d'un objet à détecter passant sensiblement à égale distance des deux capteurs magnétiques.
- La figure 5b montre schématiquement des signaux émis par deux capteurs magnétiques en vis-à-vis d'un dispositif de détection magnétique selon un mode de réalisation de l'invention, dans le cas d'un objet à détecter passant plus proche d'un capteur magnétique que de l'autre.
- La figure 6 montre schématiquement des signaux émis par deux capteurs magnétiques successifs d'un dispositif de détection magnétique selon un mode de réalisation de l'invention, permettant d'évaluer la vitesse d'un objet à détecter.

- La figure 7 montre schématiquement une configuration préférée d'un capteur magnétique d'un dispositif de détection magnétique selon un mode de réalisation de l'invention.
- La figure 8 montre schématiquement une configuration préférée d'un aimant permanent d'un dispositif de détection magnétique selon un mode de réalisation de l'invention.
- La figure 9a montre schématiquement un exemple d'électronique de lecture d'un capteur magnétique d'un dispositif de détection magnétique selon un mode de réalisation de l'invention ou selon la première variante.
- La figure 9b montre schématiquement un exemple d'électronique de lecture d'un capteur magnétique d'un dispositif de détection magnétique selon la deuxième variante d'un mode de réalisation de l'invention.
- La figure 10a montre schématiquement une vue de dessus d'un premier demi-canal d'un dispositif de détection magnétique selon un mode de réalisation de l'invention.
- La figure 10b montre schématiquement une vue de dessous d'un second demi-canal d'un dispositif de détection magnétique selon un mode de réalisation de l'invention.
- La figure 10c montre schématiquement une vue en coupe d'un dispositif de détection magnétique selon un mode de réalisation de l'invention, comportant les premier et second demi-canaux des figures 10a et 10b, assemblés.
- La figure 10d montre schématiquement une vue en perspective du dispositif de détection magnétique de la figure 10c, montrant notamment une arrivée et une sortie adaptées pour un fluide.

Pour plus de clarté, les éléments identiques ou similaires sont repérés par des signes de référence identiques sur l'ensemble des figures.

**DESCRIPTION DETAILLEE D'AU MOINS UN MODE DE REALISATION**

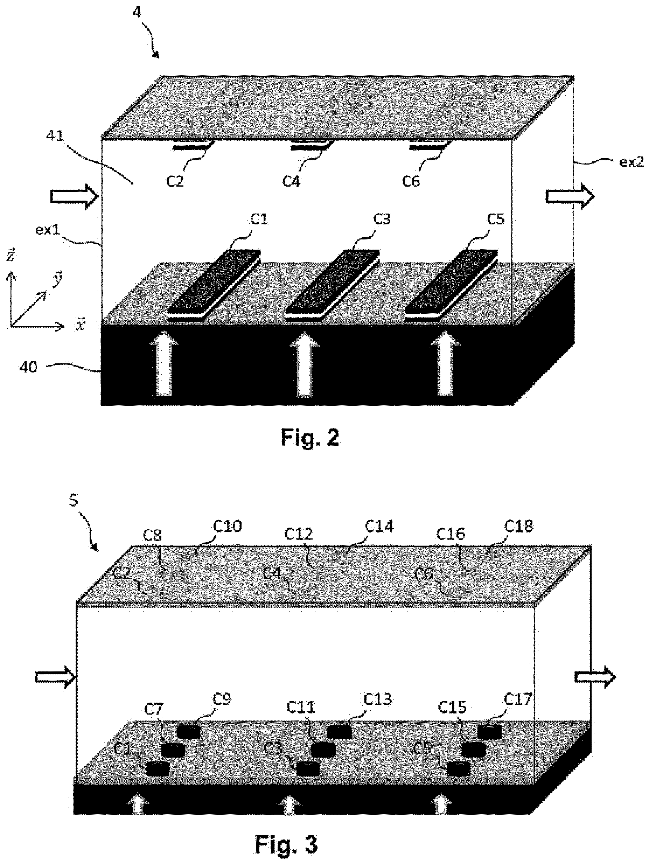

La figure 2 montre schématiquement un dispositif 4 de détection magnétique d'objets biologiques selon un premier mode de réalisation de l'invention, comportant :

- un canal microfluidique 41 s'étendant entre une première extrémité amont ex1 et une deuxième extrémité aval ex2, le canal microfluidique présentant une arrivée adaptée pour un fluide du côté de sa première extrémité amont ex1 et une sortie adaptée pour un fluide du côté de sa deuxième extrémité aval ex2,

- une pluralité de capteurs magnétiques agencés contre une paroi interne du canal microfluidique 41, et

- un aimant permanent 40 agencé contre une paroi externe du canal microfluidique 41, de manière que la pluralité de capteurs magnétiques soit plongée dans un champ magnétique créé par l'aimant permanent 40.

En chaque point du canal microfluidique 41, on définit un repère orthogonal ayant :

- une première direction $\vec{x}$ qui correspond correspondant à une direction d'écoulement au sein du canal microfluidique 41. Dans le cas où le canal microfluidique 41 est rectiligne, les première et deuxième extrémités ex1, ex2 sont alignées suivant la première direction $\vec{x}$, qui est fixe. Dans le cas où le canal microfluidique 41 n'est pas rectiligne mais courbe, la première direction $\vec{x}$ varie selon la courbure du canal microfluidique 41. La longueur du canal microfluidique 41 est mesurée suivant la première direction $\vec{x}$.

- Une deuxième direction $\vec{y}$ perpendiculaire à la première direction $\vec{x}$ et une troisième direction $\vec{z}$ perpendiculaire aux première et deuxième directions $\vec{x}, \vec{y}$. La largeur du canal microfluidique 41 est mesurée suivant la deuxième direction $\vec{y}$ et la hauteur du canal microfluidique 41 est mesurée suivant la troisième direction $\vec{z}$. L'aimant permanent 40 et le canal microfluidique 41 sont alignés suivant la troisième direction $\vec{z}$. On note que la troisième direction $\vec{z}$ est invariante quelle que soit la géométrie rectiligne ou non du canal microfluidique 41. Seules les première et deuxième directions $\vec{x}, \vec{y}$ varient selon la géométrie du canal microfluidique 41.

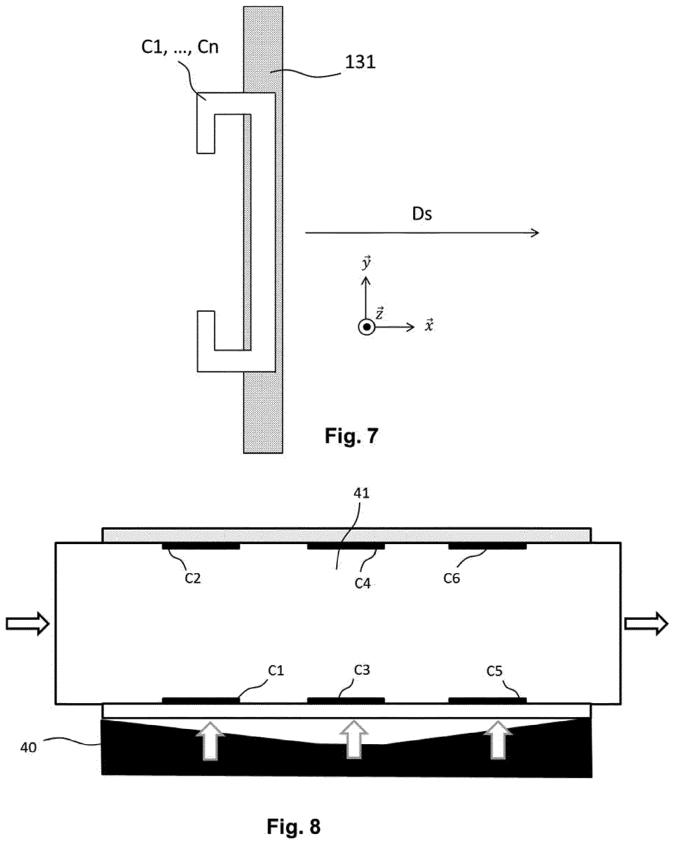

On cherche à créer au moyen de l'aimant permanent 40 un champ magnétique dont les lignes de champ sont perpendiculaires à la surface sur laquelle sont agencés les capteurs magnétiques, c'est-à-dire ici dont les lignes de champ sont colinéaires à la troisième direction $\vec{z}$. L'aimant permanent 40 peut être de forme sensiblement parallélépipédique, comme illustré notamment aux figures 2, 3, 4, avec une surface supérieure sensiblement plane et au contact d'une paroi externe du canal microfluidique 41, contre une paroi interne duquel sont agencés les capteurs magnétiques. Comme illustré à la figure 8, la face supérieure de l'aimant permanent 40 peut alternativement être creusée, de manière à présenter une tranchée de profil trapézoïdal. Cela permet de modifier les lignes de champ magnétique par rapport à la configuration parallélépipédique, afin d'améliorer et prolonger leur perpendicularité, de manière à disposer d'un champ parfaitement perpendiculaire dans une zone pouvant inclure tous les capteurs magnétiques de la pluralité de capteurs magnétiques. D'autres formes d'aimant permanent, comme par exemple un aimant permanent ayant une face supérieure creusée de manière à présenter une tranchée de profil ellipsoïdal, sont également adaptées.

Chaque capteur magnétique est préférentiellement de type magnétorésistance géante GMR ou magnétorésistance à effet tunnel TMR car ce sont ces technologies qui présentent la meilleure sensibilité et le plus faible encombrement. Alternativement, des capteurs magnétiques à magnétorésistance anisotrope AMR peuvent être utilisés mais ils sont environ cinq fois moins sensibles que les capteurs de type GMR ou TMR. Selon une autre alternative, des capteurs magnétiques à effet Hall peuvent être utilisés mais ils sont environ 50 fois moins sensibles que les capteurs de type GMR ou TMR. Selon encore une autre alternative, des capteurs magnétiques à modulation de flux (« fluxgate » en anglais » peuvent être utilisés mais ils sont plus encombrants et moins sensibles que les capteurs de type GMR ou TMR.

Les capteurs magnétorésistifs, c'est-à-dire de type GMT, TMR ou AMR, présentent une sensibilité planaire, donc en l'occurrence une sensibilité dans un plan parallèle au plan d'axes $(\vec{x}, \vec{y})$. Leur axe de sensibilité est préférentiellement choisi dans la direction du canal microfluidique 41, c'est-à-dire dans la première direction $\vec{x}$ afin que le signe du signal qu'ils émettent dépende de la position suivant la première direction $\vec{x}$ des objets à détecter. Comme illustré à la figure 7, chaque capteur magnétorésistif (référencé C1, ..., Cn), d'axe de sensibilité Ds, peut présenter une configuration en C, avec une branche principale dans la deuxième direction $\vec{y}$ prolongée de part et d'autre par des première et seconde parties recourbées, en forme de crochet. La configuration en C permet de réduire le bruit magnétique. Une ligne de courant 131 située en dessous ou en dessus de la branche principale du capteur magnétorésistif permet par ailleurs d'appliquer un champ magnétique additionnel constant sur le capteur magnétorésistif afin d'optimiser sa sensibilité.

La largeur du canal microfluidique 41 est choisie en fonction du débit souhaité. Une largeur dans la deuxième direction $\vec{y}$ supérieure à 100 μm pourra par exemple être choisie. La hauteur du canal microfluidique 41 est choisie en fonction du type d'objets à détecter. Ainsi, pour des objets à détecter de plusieurs micromètres de diamètre, tels que des cellules, le canal microfluidique 41 peut présenter une hauteur dans la troisième direction $\vec{z}$ comprise entre 20 μm et 30 μm. Pour des objets à détecter de diamètre inférieur au micromètre, le canal microfluidique 41 peut plutôt présenter une hauteur dans la troisième direction $\vec{z}$ comprise entre 2 μm et 10 μm.

Chaque capteur magnétique peut présenter dans la première direction $\vec{x}$ une longueur maximum comprise entre 1 μm et 5 μm. Deux capteur magnétiques consécutifs dans la première direction ou direction d'écoulement $\vec{x}$ peuvent être séparés dans cette première direction $\vec{x}$ par une distance par exemple au moins égale à 2 μm, ou 5 μm, ou 10 μm, et par exemple au maximum égale à 100 μm, ou 150 μm, ou 200 μm. L'es-

pacement en longueur peut être régulier ou irrégulier. Un espacement en longueur irrégulier permet d'utiliser le dispositif de détection selon un mode de réalisation de l'invention de manière polyvalente, pour des objets à détecter de différentes dimensions. Deux capteurs magnétiques consécutifs dans la deuxième direction ou largeur $\vec{y}$ peuvent être séparés dans cette deuxième direction $\vec{y}$ par une distance par exemple comprise entre 20$\mu$m et 100$\mu$m. L'espacement en largeur peut être régulier ou irrégulier. Un espacement régulier en longueur et en largeur permet de déterminer la trajectoire d'un objet à détecter de manière plus aisée. L'espacement en hauteur est quant à lui déterminé par la hauteur du canal microfluidique 41.

La pluralité de capteurs magnétiques comporte au moins :

- un premier capteur magnétique C1,

- un deuxième capteur magnétique C2 agencé en vis-à-vis du premier capteur magnétique C1, de manière que les premier et deuxième capteurs magnétiques C1, C2 soient alignés parallèlement à la troisième direction $\vec{z}$, et

- un troisième capteur magnétique C3 agencé de manière que les premier et troisième capteurs magnétiques C1, C3 soient alignés parallèlement à la première direction $\vec{x}$, ou un quatrième capteur magnétique C4 agencé de manière que les premier et quatrième capteurs magnétiques soient alignés parallèlement à la première direction $\vec{x}$, les troisième et quatrième capteurs magnétiques C3, C4 étant agencés en aval des premier et deuxième capteurs magnétiques C1, C2.

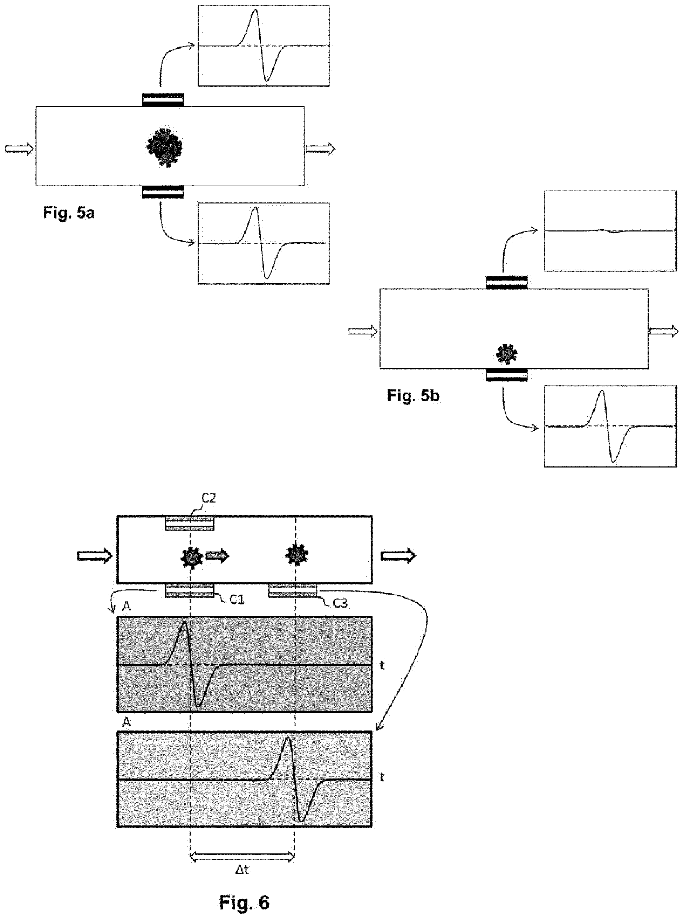

Les premier et deuxième capteurs magnétiques C1, C2 appartiennent à un premier plan de mesure normal à la première direction ou direction d'écoulement $\vec{x}$. Lorsqu'un objet à détecter progresse dans le canal microfluidique 41 et parvient au niveau du premier plan de mesure et des premier et deuxième capteurs magnétiques C1, C2 qui se font face de part et d'autre de la paroi interne du canal microfluidique 41, chaque capteur magnétique C1, C2 émet un signal qui est d'autant plus fort qu'il détecte un magnétisme important. Le rapport des signaux émis par les premier et deuxième capteurs magnétiques C1, C2 fournit donc une information sur la hauteur de l'objet au sein du canal microfluidique 41 au moment de la mesure. Ce point est plus particulièrement illustré aux figures 5a et 5b. La figure 5a montre schématiquement des signaux émis par deux capteurs magnétiques en vis-à-vis d'un dispositif de détection magnétique selon un mode de réalisation de l'invention, dans le cas d'un objet à détecter passant sensiblement à égale distance des deux capteurs magnétiques. Dans ce cas, les deux signaux émis sont sensiblement de même amplitude et leur rapport sera proche de 1. La figure 5b montre schématiquement des signaux émis par deux capteurs magnétiques en vis-à-vis d'un dispositif de détection magnétique selon un mode de réalisation de l'invention, dans le cas d'un objet à détecter passant plus proche d'un capteur magnétique que de l'autre. Dans ce cas, le capteur magnétique le plus proche de l'objet à détecter émet un signal de plus grande amplitude que le capteur magnétique le plus éloigné de l'objet à détecter, et leur rapport sera très différent de 1. Les figures 5a et 5b montrent en particulier une forme de signal qui correspond au cas d'un objet à détecter d'aimantation perpendiculaire au plan des capteurs magnétiques.

Les troisième et quatrième capteurs magnétiques C3, C4 appartiennent à un deuxième plan de mesure normal à la première direction ou direction d'écoulement $\vec{x}$. Le deuxième plan de mesure se trouve en aval du premier plan de mesure. Les troisième et/ou quatrième capteurs magnétiques C3, C4, agencés en aval des premier et deuxième capteurs magnétiques C1, C2, permettent en combinaison avec ces derniers d'obtenir une information de vitesse d'écoulement d'un objet à détecter. Ce point est plus particulièrement illustré à la figure 6, qui montre schématiquement des signaux émis par deux capteurs magnétiques successifs d'un dispositif de détection magnétique selon un mode de réalisation de l'invention, permettant d'évaluer la vitesse d'un objet à détecter. Il s'agit en l'occurrence des premier et troisième capteurs magnétiques C1, C3 mais il pourrait également s'agir des deuxième et troisième capteurs magnétiques C2, C3 et d'une manière générale, selon le nombre et l'agencement des capteurs magnétiques de la pluralité de capteurs magnétiques, d'autres configurations sont également possibles. S'il y a trois capteurs magnétiques successifs ou plus, on peut utiliser deux capteurs magnétiques non consécutifs, par exemple deux capteurs magnétiques aux extrémités, pour augmenter voire maximiser la distance entre les deux capteurs magnétiques servant à calculer la vitesse. On peut également calculer la vitesse plusieurs fois, à partir de différents binômes : une telle redondance permet d'améliorer la précision du résultat notamment si les signaux sont bruités. Une information d'aimantation d'un objet à détecter est alors obtenue à partir des informations de hauteur et de vitesse.

Lorsque la pluralité de capteurs magnétiques comporte à la fois les troisième et quatrième capteurs magnétiques C3, C4, avec le quatrième capteur magnétique C4 agencé en vis-à-vis du troisième capteur magnétique C3 de manière que les troisième et quatrième capteurs magnétiques C3, C4 soient alignés parallèlement à la troisième direction $\vec{z}$, cela permet en outre d'obtenir, par le rapport des signaux émis par les troisième et quatrième capteurs magnétiques C3, C4, une nouvelle information sur la hauteur de l'objet au sein du canal microfluidique 41 au moment de la mesure.

La pluralité de capteurs magnétiques peut en outre comporter :

- un cinquième capteur magnétique C5 agencé de manière que les premier et cinquième capteurs magnétiques C1, C5 soient alignés parallèlement à la première direction $\vec{x}$, et/ou

- un sixième capteur magnétique C6 agencé de manière que les deuxième et sixième capteurs magnétiques C2, C6 soient alignés parallèlement à la première direction $\vec{x}$, les cinquième et sixième capteurs magnétiques C5, C6 étant agencés en aval des troisième et quatrième capteurs magnétiques C3, C4.

Les cinquième et sixième capteurs magnétiques C5, C6 appartiennent à un troisième plan de mesure normal à la première direction ou direction d'écoulement $\vec{x}$. Le troisième plan de mesure se trouve en aval des premier et deuxième plans de mesure. Les cinquième et/ou sixième capteurs magnétiques C5, C6, agencés en aval des troisième et/ou quatrième capteurs magnétiques C3, C4 permettent d'améliorer la fiabilité du dispositif 4 par une détection d'éventuels faux positifs. Lorsqu'un premier signal de détection a été émis par au moins un capteur du premier plan de mesure, suivi d'un deuxième signal de détection émis par au moins un capteur du deuxième plan de mesure, une première vitesse d'écoulement est calculée à partir de la distance séparant les premier et deuxième plans de mesure et de l'intervalle de temps séparant les premier et deuxième signaux de détection successifs. Si au moins capteur du troisième plan de mesure émet à son tour un troisième signal de détection, une deuxième vitesse d'écoulement est calculée à partir de la distance séparant les deuxième et troisième plans de mesure et de l'intervalle de temps séparant les deuxième et troisième signaux de détection successifs. Une détection d'un objet est alors véritablement confirmée si les première et deuxième vitesses d'écoulement sont compatibles entre elles, c'est-à-dire si la différence entre les première et deuxième vitesses est inférieure ou égale à 50%, voire 30%, de la moyenne des première et deuxième vitesses. Si aucun capteur du troisième plan de mesure n'émet de troisième signal de détection, ou s'il l'émet trop tôt ou trop tard de sorte que la deuxième vitesse d'écoulement est incompatible avec la première vitesse d'écoulement précédemment calculée, on considère qu'aucun objet n'a été détecté.

Lorsque la pluralité de capteurs magnétiques comporte à la fois les cinquième et sixième capteurs magnétiques C5, C6, avec le sixième capteur magnétique C6 agencé en vis-à-vis du cinquième capteur magnétique C5 de manière que les cinquième et sixième capteurs magnétiques C5, C6 soient alignés parallèlement à la troisième direction $\vec{z}$, cela permet en outre d'obtenir, par le rapport des signaux émis par les cinquième et sixième capteurs magnétiques C5, C6, encore une nouvelle information sur la hauteur de l'objet au sein du canal microfluidique 41 au moment de la mesure. Disposer de plusieurs informations de hauteur issues de plusieurs binômes de capteurs magnétiques en vis-à-vis permet d'obtenir une information de trajectoire d'un objet à détecter, et notamment de détecter une trajectoire non parallèle au plan des capteurs magnétiques, c'est-à-dire au plan d'axes $\vec{x}$, $\vec{y}$. Le critère choisi pour définir si des première et deuxième vitesses d'écoulement sont compatibles entre elles ou non peut alors être modifié, adapté en fonction de cette information de trajectoire. En effet, la vitesse d'un objet varie en fonction de sa hauteur au sein du canal microfluidique 41.

La figure 3 montre schématiquement un dispositif 5 de détection magnétique d'objets biologiques selon un deuxième mode de réalisation de l'invention. En plus des capteurs magnétiques du dispositif 4 selon le premier mode de réalisation, selon chaque combinaison possible précédemment décrite, la pluralité de capteurs magnétiques du dispositif 5 selon le deuxième mode de réalisation comporte au moins :

- un septième capteur magnétique C7 agencé de manière que les premier et septième capteurs magnétiques C1, C7 soient alignés parallèlement à la deuxième direction $\vec{y}$, et

- un huitième capteur magnétique C8 agencé de manière que les deuxième et huitième capteurs magnétiques C2, C8 soient alignés parallèlement à la deuxième direction $\vec{y}$. Les septième et huitième capteurs magnétiques C7, C8 sont de préférence alignés parallèlement à la troisième direction $\vec{z}$.

Les septième et huitième capteurs magnétiques C7, C8 appartiennent au premier plan de mesure, avec les premier et deuxième capteurs magnétiques C1, C2. Avec quatre capteurs magnétiques dans le premier plan de mesure, pour chacun des six binômes de deux capteurs magnétiques parmi quatre, à savoir : (C1, C2), (C7, C8), (C1, C7), (C2, C8), (C1, C8), (C2, C7), on calcule un rapport des signaux émis et ces six rapports permettent d'obtenir une information de forme d'un objet à détecter passant au niveau du premier plan de mesure. On met de préférence à profit tous les capteurs de la pluralité de capteurs en calculant tous les rapports possibles, mais on pourrait alternativement ne calculer qu'une partie des rapports possibles. Cette information de forme, en plus de l'information d'aimantation, est particulièrement utile pour permettre la détection de petits objets, comme des protéines, avec une bonne spécificité, c'est-à-dire sans les confondre avec une nanoparticule magnétique libre ou un agrégat de nanoparticules magnétiques libre. En effet, comme peu de nanoparticules magnétiques peuvent se fixer sur un petit objet, par exemple seulement une, deux ou trois, il peut avoir la même aimantation qu'une nanoparticule magnétique libre ou qu'un agrégat de nanoparticules libre. Dans le deuxième mode de réalisation où l'on recherche une information supplémentaire de forme de l'objet à détecter, la hauteur du canal microfluidique 41 et de chaque capteur magnétique, ainsi que l'espacement en longueur et en largeur entre les capteurs magnétiques, sont de préférence inférieurs à 30 fois la taille de l'objet à détecter, encore plus préférentiellement inférieurs à 20 fois la taille de l'objet à détecter. Cela permet qu'un même objet puisse effectivement être détecté simultanément par plusieurs capteurs magnétiques.

En plus des septième et huitième capteurs magnétiques C7, C8, la pluralité de capteurs magnétiques selon le deuxième mode de réalisation peut également comporter :

- un neuvième capteur magnétique C9 agencé de manière que les premier, septième et neuvième capteurs magnétiques C1, C7, C9 soient alignés, et

- un dixième capteur magnétique C10 agencé de manière que les deuxième, huitième et dixième capteurs magnétiques C2, C8, C10 soient alignés. Les neuvième et dixième capteurs magnétiques C9, C10 sont de préférence alignés parallèlement à la troisième direction $\vec{z}$.

Les neuvième et dixième capteurs magnétiques C9, C10 appartiennent au premier plan de mesure, avec les premier, deuxième, septième et huitième capteurs magnétiques C1, C2, C7, C8. Avec six capteurs dans le premier plan de mesure, pour chacun des quinze binômes de deux capteurs magnétiques parmi six, à savoir, en plus des six binômes précédemment listés : (C1, C9), (C1, C10), (C2, C9), (C2, C10), (C7, C9), (C7, C10), (C8, C9), (C8, C10), (C9, C10), on calcule un rapport des signaux émis et ces quinze rapports permettent d'obtenir une information de forme d'un objet à détecter passant au niveau du premier plan de mesure, plus précise qu'avec seulement quatre capteurs et six rapports. On met de préférence à profit tous les capteurs de la pluralité de capteurs en calculant tous les rapports possibles, mais on pourrait alternativement ne calculer qu'une partie des rapports possibles.

En plus des troisième et quatrième capteurs magnétiques C3, C4, la pluralité de capteurs magnétiques selon le deuxième mode de réalisation peut également comporter :

- un onzième capteur magnétique C11 agencé de manière que les troisième et onzième capteurs magnétiques C3, C11 soient alignés parallèlement à la deuxième direction $\vec{y}$, et

- un douzième capteur magnétique C12 agencé de manière que les quatrième et douzième capteurs magnétiques C4, C12 soient alignés parallèlement à la deuxième direction $\vec{y}$. Les onzième et douzième capteurs magnétiques C11, C12 sont de préférence alignés parallèlement à la troisième direction $\vec{z}$.

Les onzième et douzième capteurs magnétiques C11, C12 appartiennent au deuxième plan de mesure, avec les troisième et quatrième capteurs magnétiques C3, C4. De même que pour le premier plan de mesure, on calcule, pour chacun des six binômes de deux capteurs magnétiques parmi les quatre capteurs magnétiques du deuxième plan de mesure, un rapport des signaux émis et ces six rapports permettent d'obtenir une information de forme d'un objet à détecter passant au niveau du deuxième plan de mesure. On obtient donc une information de forme de l'objet à détecter dans le deuxième plan de mesure, en plus de celle déjà obtenue dans le premier plan de mesure.

En plus des onzième et douzième capteurs magnétiques C11, C12, la pluralité de capteurs magnétiques selon le deuxième mode de réalisation peut également comporter :

- un treizième capteur magnétique C13 agencé de manière que les troisième, onzième et treizième capteurs magnétiques C3, C11, C13 soient alignés, et

- un quatorzième capteur magnétique C14 agencé de manière que les quatrième, douzième et quatorzième capteurs magnétiques C4, C12, C14 soient alignés. Les treizième et quatorzième capteurs magnétiques C13, C14 sont de préférence alignés parallèlement à la troisième direction $\vec{z}$.

Les treizième et quatorzième capteurs magnétiques C13, C14 appartiennent au deuxième plan de mesure, avec les troisième, quatrième, onzième et douzièmes capteurs magnétiques C3, C4, C11, C12. De même que pour le premier plan de mesure, on calcule, pour chacun des quinze binômes de deux capteurs magnétiques parmi les six capteurs magnétiques du deuxième plan de mesure, un rapport des signaux émis et ces quinze rapports permettent d'obtenir une information de forme d'un objet à détecter passant au niveau du deuxième plan de mesure, plus précise qu'avec seulement quatre capteurs et six rapports.

En plus des cinquième et sixième capteurs magnétiques C5, C6, la pluralité de capteurs magnétiques selon le deuxième mode de réalisation peut également comporter :

- un quinzième capteur magnétique C15 agencé de manière que les cinquième et quinzième capteurs magnétiques C5, C15 soient alignés parallèlement à la deuxième direction $\vec{y}$, et

- un seizième capteur magnétique C16 agencé de manière que les sixième et seizième capteurs magnétiques C6, C16 soient alignés parallèlement à la deuxième direction $\vec{y}$. Les quinzième et seizième capteurs magnétiques C15, C16 sont de préférence alignés parallèlement à la troisième direction $\vec{z}$.

Les quinzième et seizième capteurs magnétiques C15, C16 appartiennent au troisième plan de mesure, avec les cinquième et sixième capteurs magnétiques C5, C6. De même que pour le premier plan de mesure et, le cas échéant, le deuxième plan de mesure, on calcule, pour chacun des six binômes de deux capteurs magnétiques parmi les quatre capteurs magnétiques du troisième plan de mesure, un rapport des signaux émis et ces six rapports permettent d'obtenir une information de forme d'un objet à détecter passant au niveau du troisième plan de mesure. On obtient donc une information de forme de l'objet à détecter dans le troisième plan de mesure, en plus de celle déjà obtenue dans le premier plan de mesure et, le cas échéant, dans le deuxième plan de mesure.

En plus des quinzième et seizième capteurs magnétiques C15, C16, la pluralité de capteurs magnétiques selon le deuxième mode de réalisation peut également comporter :

- un dix-septième capteur magnétique C17 agencé de manière que les cinquième, quinzième et dix-septième capteurs magnétiques C5, C15, C17 soient alignés, et

- un dix-huitième capteur magnétique C18 agencé de manière que les sixième, seizième et dix-huitième capteurs magnétiques C6, C16, C18 soient alignés. Les dix-septième et dix-huitième capteurs C17, C18 sont de préférence alignés parallèlement à la troisième direction $\vec{z}$.

Les dix-septième et dix-huitième capteurs magnétiques C17, C18 appartiennent au troisième plan de mesure, avec les cinquième, sixième, quinzième et seizième capteurs magnétiques C5, C6, C16, C17. De même que pour les premier et deuxième plans de mesure, on calcule, pour chacun des quinze binômes de deux capteurs magnétiques parmi les six capteurs magnétiques du troisième plan de mesure, un rapport des signaux émis et ces quinze rapports permettent d'obtenir une information de forme d'un objet à détecter passant au niveau du troisième plan de mesure, plus précise qu'avec seulement quatre capteurs et six rapports.

D'une manière générale, plus le réseau de capteurs selon le deuxième mode de réalisation est dense, c'est-à-dire plus il y a de plans de mesure et/ou de capteurs par plan de mesure, plus la qualité de l'information de forme d'un objet à détecter est importante.

Le dispositif de détection magnétique selon l'un quelconque des modes de réalisation de l'invention peut comporter un système d'acquisition, avec une voie par capteur magnétique. La fréquence d'acquisition est choisie nettement supérieure à l'inverse du temps moyen de passage d'un objet à détecter devant un capteur magnétique. On entend par « temps moyen » le temps mis par un objet circulant à vitesse moyenne pour parcourir entre 5 et 15 fois, par exemple 10 fois, une distance égale à la longueur du capteur magnétique, dans la première direction $\vec{x}$. Ce temps moyen de passage peut par exemple être de 1 ms et dans ce cas, la fréquence d'acquisition peut par exemple être choisie supérieure ou égale à 50 kHz.

Le dispositif de détection magnétique selon l'un quelconque des modes de réalisation peut comporter un système de traitement de données mettant par exemple en œuvre les étapes suivantes :

- le système de traitement de données considère qu'un capteur magnétique détecte un évènement lorsque ledit capteur magnétique émet un signal qui dépasse un seuil, fixé par exemple à deux ou trois fois le bruit RMS ;

- le système de traitement de données considère qu'un évènement détecté est pertinent si au moins trois capteurs magnétiques espacés en longueur, suivant la première direction $\vec{x}$, détectent un évènement dans une même fenêtre temporelle, par exemple de 10 ms et si lesdites détections sont temporellement cohérentes entre elles. Par exemple, deux détections seront considérées temporellement incohérentes entre elle si la détection par un capteur magnétique aval a lieu avant la détection par un capteur magnétique amont.

- Pour chaque évènement pertinent :

   ○ le système de traitement de données détermine une vitesse de l'objet à détecter à partir du temps écoulé entre deux détections dudit évènement pertinent par deux capteurs magnétiques espacés en longueur suivant la première direction $\vec{x}$ ;

   ○ le système de traitement de données détermine une hauteur de l'objet à détecter à partir du rapport des signaux émis par au moins un couple de deux capteurs magnétiques en vis-à-vis, espacés en hauteur suivant la troisième direction $\vec{z}$, l'un des deux capteurs magnétiques du couple ayant contribué à la pertinence. De préférence, lorsqu'un seul capteur magnétique d'un couple détecte un signal, le système de traitement de données élimine l'évènement pertinent. On estime en effet que cela correspond probablement au cas d'une nanoparticule magnétique ou d'un agrégat de nanoparticules non fixés à un objet à détecter ;

   ○ le système de traitement de données détermine un moment magnétique de l'objet à détecter et une orientation dudit moment magnétique, à partir de la vitesse et de la hauteur préalablement déterminées. Le système de traitement de données détermine plus particulièrement l'orientation du moment magnétique à partir de l'asymétrie des signaux émis par les deux capteurs magnétiques en vis-à-vis, qui permet d'accéder à l'angle entre l'aimantation de l'objet à détecter et le plan des capteurs magnétiques.

Le système de traitement de données peut en outre comparer le moment magnétique avec un niveau bas prédéterminé et un niveau haut prédéterminé, et considérer qu'un objet biologique valide a effectivement été détecté en fonction du résultat de cette comparaison.

Selon le deuxième mode de réalisation, le système de traitement de données peut en outre tracer une trajectoire de l'objet à détecter et déterminer une forme de l'objet à détecter. Le système de traitement de données peut alors comparer la forme obtenue à une forme prédéterminée préalablement obtenue de l'objet à détecter, par exemple contenues dans une base de données, et considérer qu'un objet recherché a effectivement été détecté en fonction du résultat de cette comparaison. Pour déterminer une forme approximative de l'objet à détecter, le système de traitement de données utilise les amplitudes des signaux correspondant à l'ensemble des évènements détectés pertinents à un instant t. Il s'agit d'un problème inverse dont la solution n'est pas unique a priori. Introduire un ou plusieurs modèles prédéterminés, comme par exemple une boule ou des haltères, permet généralement de déterminer la taille et l'orientation de l'objet à détecter, et s'il correspond ou non à une forme prédéterminée.

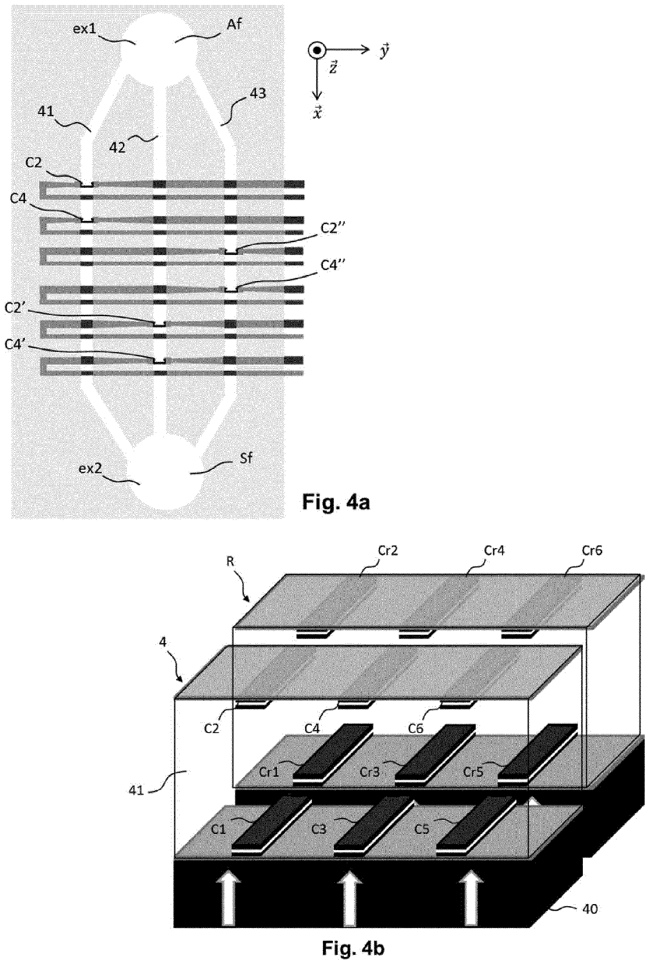

La figure 4a montre schématiquement une vue de dessus d'un dispositif de détection magnétique d'objets biologiques selon une première variante de l'un quelconque des modes de réalisation de l'invention. Cette première variante est plus particulièrement illustrée à la figure 4a dans le cas du premier mode de réalisation de la figure 2 mais elle est également compatible avec le deuxième mode de réalisation de la figure 3. Le dispositif de détection selon la première variante comporte une pluralité de canaux microfluidiques en parallèle, avec une arrivée Af adaptée pour un fluide commune au niveau de leur première extrémité ex1 et une sortie Sf adaptée pour un fluide commune au niveau de leur deuxième extrémité ex2. Cela permet d'augmenter le débit de détection des objets biologiques. Dans l'exemple de la figure 4a, le dispositif selon la deuxième variante comporte, en plus du canal microfluidique 41, des deuxième et troisième canaux microfluidiques 42, 43. Le dispositif selon la première variante pourrait ne comporter que deux canaux microfluidiques en parallèle, ou bien quatre canaux microfluidiques ou plus en parallèle.

La figure 4b montre schématiquement un dispositif de détection magnétique d'objets biologiques selon une deuxième variante de l'un quelconque des modes de réalisation de l'invention. La deuxième variante est plus particulièrement illustrée à la figure 4b dans le cas du premier mode de réalisation de la figure 2 mais elle est également compatible avec le deuxième mode de réalisation de la figure 3. La deuxième variante est compatible avec la première variante. Selon cette deuxième variante, on prévoit :

- un dispositif de détection selon l'un quelconque des modes de réalisation, tel que précédemment décrit, et

- une réplique R dudit dispositif de détection, agencée à côté dudit dispositif de détection et selon la même orientation spatiale que ledit dispositif de détection.

La réplique R est identique au dispositif de détection, sauf en ce qui concerne l'arrivée et la sortie adaptées pour un fluide : la réplique peut ne pas en comporter car son canal n'est pas destiné à faire circuler un fluide. Chaque capteur magnétique du dispositif de détection est associé à un capteur magnétique « jumeau » de la réplique : dans l'exemple particulier de la figure 4b, le premier capteur magnétique C1 est associé au premier capteur magnétique jumeau Cr1, etc. La première variante permet de soustraire, pour chaque couple capteur magnétique/capteur magnétique jumeau, le signal émis par le capteur magnétique jumeau de la réplique du signal émis par le capteur magnétique du dispositif de détection, afin d'éliminer les erreurs induites par d'éventuelles fluctuations de températures et/ou bruit magnétique extérieur.

D'une manière générale, la réplique R selon la deuxième variante peut ne pas comporter de canal mais simplement :

- une pluralité de capteurs magnétiques jumeaux, chaque capteur magnétique jumeau étant associé à un capteur magnétique du dispositif de détection, chaque capteur magnétique jumeau étant agencé sur un support faisant saillie du canal microfluidique 41, dans le prolongement de la paroi contre laquelle est agencé le capteur magnétique du dispositif de détection auquel il est associé ; et

- un aimant permanent agencé dans le prolongement de l'aimant permanent du dispositif de détection de manière que la pluralité de capteurs magnétiques jumeaux voie le même champ magnétique que la pluralité de capteurs magnétiques du dispositif de détection, l'aimant permanent de la réplique étant éventuellement monobloc avec l'aimant permanent du dispositif de détection.

Chaque capteur magnétique est relié à une électronique de lecture qui peut être intégrée au dispositif de détection, ou non intégrée au dispositif de détection.

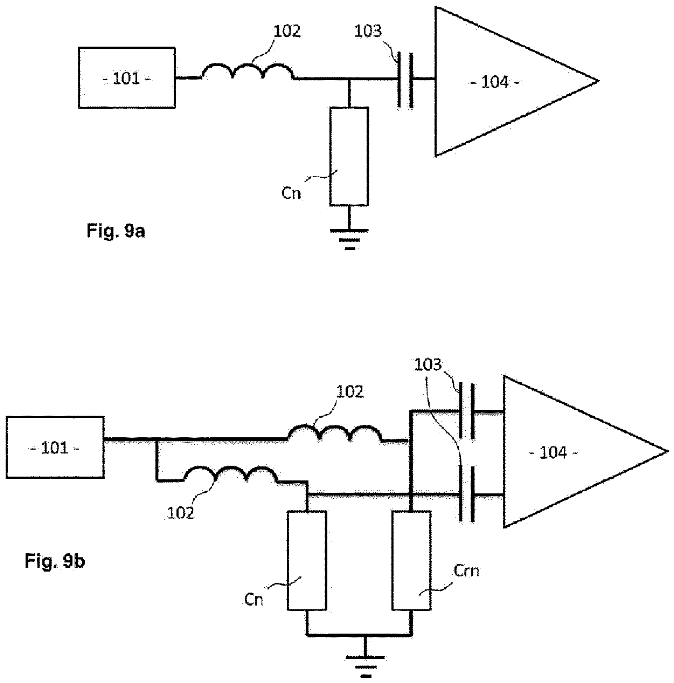

La figure 9a montre schématiquement un exemple d'électronique de lecture d'un capteur magnétorésistif (référencé Cn), d'un dispositif de détection magnétique selon un mode de réalisation de l'invention ou selon la première variante. Une source de tension DC 101 permet d'alimenter le capteur magnétorésistif Cn à travers une inductance 102. Une variation de résistance due à un champ créé par un objet à détecter induit un pic de tension AC qui est détecté à travers une capacité 103 puis amplifié par un amplificateur bas bruit 104. L'inductance 102 peut être choisie pour atténuer fortement les signaux émis par le capteur magnétorésistif, généralement supérieurs à 1 kHz, afin d'éviter qu'ils ne perturbent la source de tension DC 101, donc telle que :

$$\frac{2\pi L f}{R} > 10$$

avec L la valeur de l'inductance 102, f l'inverse du temps de passage maximal et R la résistance du capteur magnétorésistif Cn. On entend par « temps de passage maximal » le temps mis par l'objet le plus lent pour parcourir entre 5 et 10 fois, par exemple 10 fois, une distance égale à la longueur du capteur magnétique, dans la première direction $\vec{x}$. La capacité 103 peut être choisie pour ne pas atténuer le signal. Elle peut être prise aussi grande que possible moyennant les contraintes spatiales du dispositif. Des valeurs comprises entre 1 $\mu$F et 100 $\mu$F, par exemple 10 $\mu$F, peuvent être utilisées.

La figure 9b montre schématiquement un exemple d'électronique de lecture d'un couple capteur magnétorésistif (référencé Cn)/capteur magnétorésistif jumeau (référencé Crn) du dispositif de détection magnétique selon la deuxième variante d'un mode de réalisation de l'invention. Les inductances 102 et capacités 103 sont choisies de la même manière que décrit en lien avec la figure 9a. L'amplificateur 104 est configuré en mode différentiel.

Un dispositif de détection selon l'un quelconque des modes et variantes de réalisation de l'invention peut être fabriqué en utilisant des technologies de microélectronique, par exemple au moyen des étapes suivantes :

- la pluralité de capteurs magnétiques étant formée d'un premier groupe de capteurs magnétiques et d'un second groupe de capteurs magnétiques en vis-à-vis du premier groupe : fabriquer, par une technologie de microélectronique, le premier groupe de capteurs magnétiques dans un premier wafer ou dans une première partie d'un wafer, et le second groupe de capteurs magnétiques dans un second wafer ou dans une seconde partie du wafer. Le wafer, ou les premier et second wafer, peuvent par exemple être en silicium ou en verre.

- Fabriquer un premier demi-canal sur le premier groupe de capteurs magnétiques, et fabriquer un second demi-canal sur le second groupe de capteurs magnétiques. Le premier demi-canal peut être réalisé par photolithographie ou découpe mécanique dans un premier support ou dans une première partie d'un support agencé sur le premier groupe de capteurs magnétiques. De même, le second demi-canal peut être réalisé par photolithographie ou découpe mécanique dans un second support ou dans une seconde partie du support agencé sur le second groupe de capteurs magnétiques. Le support, ou les premier et second supports, peuvent par exemple être en oxyde par exemple de type dioxyde de silicium $SiO_2$, en polymère ou en résine composite.

- Percer une arrivée adaptée pour un fluide à une première extrémité du premier demi-canal et/ou du second demi-canal, et percer une sortie adaptée pour un fluide à une seconde extrémité du premier demi-canal et/ou de second demi-canal.

- Assembler les premier et second demi-canaux de manière à obtenir un canal complet et de manière que le premier groupe de capteurs magnétiques se trouve agencé en vis-à-vis du second groupe de capteurs magnétiques.

- Réaliser une reprise de contact pour chaque capteur magnétique de la pluralité de capteurs magnétiques.

Chaque capteur magnétique peut être passivé, par exemple avec de l'alumine ou du nitrure de silicium $Si_3N_4$, par exemple sur une épaisseur d'au moins 200 nm. Cela permet de protéger chaque capteur magnétique contre une destruction par un fluide, par exemple un fluide biologique, circulant ultérieurement dans le canal microfluidique. Les premier et second demi-canaux sont alors fabriqués sur le matériau de passivation des capteurs magnétiques.

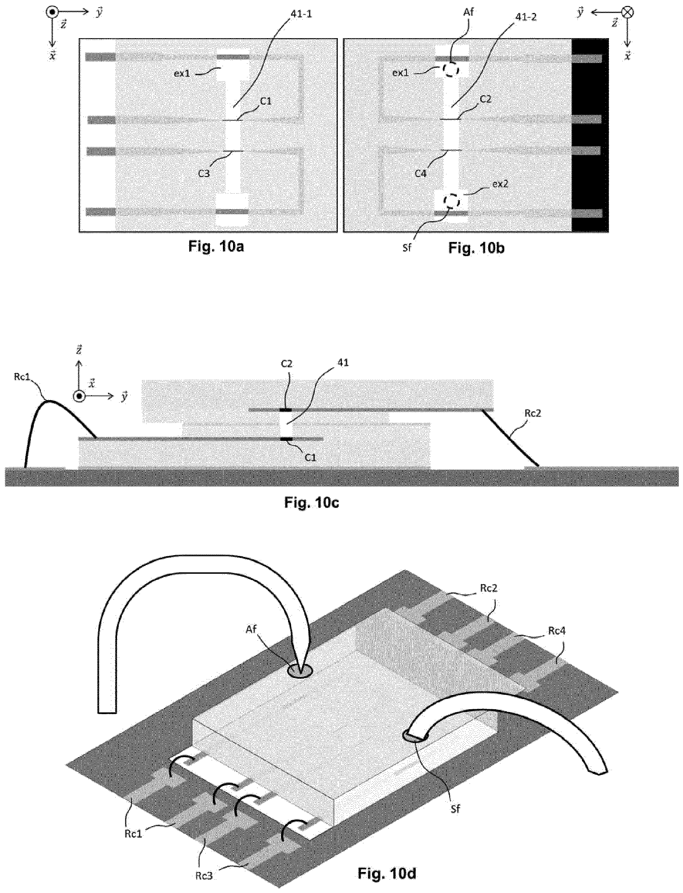

La figure 10a montre schématiquement une vue de dessus d'un premier demi-canal 41-1 comportant des premier et troisième capteurs magnétiques C1, C3. La figure 10b montre schématiquement une vue de dessous d'un second demi-canal 41-2 comportant des deuxième et quatrième capteurs magnétiques C2, C4. La figure 10b montre également une arrivée Af adaptée pour un fluide à la première extrémité ex1 du second demi-canal 41-2 et une sortie Sf adaptée pour un fluide à la seconde extrémité ex2 du second demi-canal 41-2. La figure 10c montre schématiquement une vue en coupe d'un assemblage des premier et second demi-canaux 41-1, 41-2 des figures 10a et 10b, de manière à former un canal microfluidique 41. La figure 10c montre également une première reprise de contact Rc1 du premier capteur magnétique C1 et une deuxième reprise de contact Rc2 du deuxième capteur magnétique C2. La figure 10d montre schématiquement une vue en perspective du dispositif de la figure 10c. La figure 10d montre particulièrement l'arrivée Af adaptée pour un fluide et la sortie Sf adaptée pour un fluide, les première et deuxième reprises de contact Rc1, Rc2 ainsi qu'une troisième reprise de contact Rc3 du troisième capteur magnétique C3 et une quatrième reprise de contact Rc4 du quatrième capteur magnétique C4.

**Revendications**

1. Dispositif (4, 5) de détection magnétique d'objets biologiques microscopiques comportant :

   - un canal microfluidique (41) s'étendant entre une première extrémité amont (ex1) et une deuxième extrémité aval (ex2), le canal microfluidique présentant une arrivée adaptée pour un fluide (Af) du côté de sa première extrémité amont (ex1) et une sortie adaptée pour un fluide (Sf) du côté de sa deuxième extrémité aval (ex2), le canal microfluidique (41) ayant une longueur dans une première direction $(\vec{x})$ d'écoulement, une largeur dans deuxième direction $(\vec{y})$ perpendiculaire à la première direction $(\vec{x})$ et une hauteur dans une troisième direction $(\vec{z})$ perpendiculaire aux première et deuxième directions $(\vec{x}, \vec{y})$;
   - une pluralité de capteurs magnétiques (C1, C2, ..., Cn) agencés contre une paroi interne du canal microfluidique (41) ; et
   - un aimant permanent (40) agencé contre une paroi externe du canal microfluidique (41), de manière que la pluralité de capteurs magnétiques (C1, C2, ..., Cn) soit plongée dans un champ magnétique créé par l'aimant permanent (40) ; la

   pluralité de capteurs magnétiques (C1, C2, ..., Cn) comporte :

   - un premier capteur magnétique (C1) ;
   - un deuxième capteur magnétique (C2) en vis-à-vis du premier capteur magnétique (C1) de manière que les premier et deuxième capteurs magnétiques (C1, C2) soient alignés parallèlement à la troisième direction $(\vec{z})$ ;
   - un troisième capteur magnétique (C3) agencé de manière que les premier et troisième capteurs magnétiques (C1, C3) soient alignés parallèlement à la première direction $(\vec{x})$ et/ou un quatrième capteur magnétique (C4) agencé de manière que les deuxième et quatrième capteurs magnétiques (C2, C4) soient alignés parallèlement à la première direction $(\vec{x})$ ; les troisième et quatrième capteurs magnétiques (C3, C4) étant agencés en aval des premier et deuxième capteurs magnétiques (C1, C2) ;
   - un système de traitement de données configuré pour déterminer une vitesse d'un objet détecté à partir du temps écoulé entre deux détections d'un évènement pertinent par deux capteurs alignés parallèlement à la première direction $(\vec{x})$ et pour déterminer une hauteur d'un objet détecté à partir du rapport des signaux émis par au moins un couple de capteurs en vis-à-vis.

2. Dispositif (4, 5) selon la revendication précédente **caractérisé en ce que** la pluralité de capteurs magnétiques (C1, C2, ..., Cn) comporte le troisième capteur magnétique (C3) et le quatrième capteur magnétique (C4), les troisième et quatrième capteurs magnétiques (C3, C4) étant alignés parallèlement à la troisième direction $(\vec{z})$.

3. Dispositif (4, 5) selon l'une quelconque des revendications précédentes **caractérisé en ce que** la pluralité de capteurs magnétiques (C1, C2, ..., Cn) comporte un cinquième capteur magnétique (C5) agencé de manière que les premier et cinquième capteurs magnétiques (C1, C5) soient alignés parallèlement à la première direction $(\vec{x})$ et/ou un sixième capteur magnétique (C6) agencé de manière que les deuxième et sixième capteurs magnétiques (C2, C6) soient alignés parallèlement à la première direction $(\vec{x})$ ; les cinquième et sixième capteurs magnétiques (C5, C6) étant agencés en aval des troisième et quatrième capteurs magnétiques (C3, C4).

4. Dispositif (4, 5) selon la revendication précédente **caractérisé en ce que** la pluralité de capteurs magnétiques (C1, C2, ..., Cn) comporte le cinquième capteur magnétique (C5) et le sixième capteur magnétique (C6), les cinquième et sixième capteurs magnétiques (C5, C6) étant alignés parallèlement à la troisième direction $(\vec{z})$.

5. Dispositif (5) selon l'une quelconque des revendications précédentes **caractérisé en ce que** la pluralité de capteurs magnétiques (C1, C2, ..., Cn) comporte :

   - un septième capteur magnétique (C7) agencé de manière que les premier et septième capteurs magnétiques (C1, C7) soient alignés parallèlement à la deuxième direction $(\vec{y})$ et
   - un huitième capteur magnétique (C8) agencé de manière que les deuxième et huitième capteurs magnétiques (C2, C8) soient alignés parallèlement à la deuxième direction $(\vec{y})$ et que les septième et huitième capteurs magnétiques (C7, C8) soient alignés parallèlement à la troisième direction $(\vec{z})$.

6. Dispositif (5) selon la revendication précédente **caractérisé en ce que** la pluralité de capteurs magnétiques (C1, C2, ..., Cn) comporte :

   - un neuvième capteur magnétique (C9) agencé de manière que les premier, septième et neuvième capteurs magnétiques (C1, C7, C9) soient alignés, et
   - un dixième capteur magnétique (C10) agencé de manière que les deuxième, huitième et dixième capteurs magnétiques (C2, C8, C10) soient alignés et que les neuvième et dixième capteurs magnétiques (C9, C10) soient alignés parallèlement à la troisième direction ($\vec{z}$).

7. Dispositif (5) selon la revendication 2 et l'une quelconque des revendications 5 ou 6 **caractérisé en ce que** la pluralité de capteurs magnétiques (C1, C2, ..., Cn) comporte :

   - un onzième capteur magnétique (C11) agencé de manière que les troisième et onzième capteurs magnétiques (C3, C11) soient alignés parallèlement à la deuxième direction ($\vec{y}$), et
   - un douzième capteur magnétique (C12) agencé de manière que les quatrième et douzième capteurs magnétiques (C4, C12) soient alignés parallèlement à la deuxième direction (Y) et que les onzième et douzième capteurs magnétiques (C11, C12) soient alignés parallèlement à la troisième direction ($\vec{z}$).

8. Dispositif (5) selon la revendication précédente **caractérisé en ce que** la pluralité de capteurs magnétiques (C1, C2, ..., Cn) comporte :

   - un treizième capteur magnétique (C13) agencé de manière que les troisième, onzième et treizième capteurs magnétiques (C3, C11, C13) soient alignés, et
   - un quatorzième capteur magnétique (C14) agencé de manière que les quatrième, douzième et quatorzième capteurs magnétiques (C4, C12, C14) soient alignés et que les treizième et quatorzième capteurs magnétiques (C13, C14) soient alignés parallèlement à la troisième direction ($\vec{z}$).

9. Dispositif (5) selon la revendication 4 et l'une quelconque des revendications 5 à 8 **caractérisé en ce que** la pluralité de capteurs magnétiques (C1, C2, ..., Cn) comporte :

   - un quinzième capteur magnétique (C15) agencé de manière que les cinquième et quinzième capteurs magnétiques (C5, C15) soient alignés parallèlement à la deuxième direction ($\vec{y}$), et
   - un seizième capteur magnétique (C16) agencé de manière que les sixième et seizième capteurs magnétiques (C6, C16) soient alignés parallèlement à la deuxième direction ($\vec{y}$) et que les quinzième et seizième capteurs magnétiques (C15, C16) soient alignés parallèlement à la troisième direction ($\vec{z}$).

10. Dispositif (5) selon la revendication précédente **caractérisé en ce que** la pluralité de capteurs magnétiques (C1, C2, ..., Cn) comporte :

   - un dix-septième capteur magnétique (C17) agencé de manière que les cinquième, quinzième et dix-septième capteurs magnétiques (C5, C15, C17) soient alignés, et
   - un dix-huitième capteur magnétique (C18) agencé de manière que les sixième, seizième et dix-huitième capteurs magnétiques (C6, C16, C18) soient alignés et que les dix-septième et dix-huitième capteurs magnétiques (C17, C18) soient alignés parallèlement à la troisième direction ($\vec{z}$).

11. Procédé de détection magnétique d'objets biologiques microscopiques au moyen d'un dispositif (4, 5) selon l'une quelconque des revendications précédentes, le procédé comportant les étapes suivantes :

   - détection d'un évènement par un capteur magnétique donné lorsque ledit capteur magnétique réalise une mesure supérieure à un seuil prédéterminé ;
   - détection d'un évènement pertinent lorsqu'au moins deux capteurs espacés l'un de l'autre selon la première direction ($\vec{x}$) détectent chacun un évènement dans une fenêtre temporelle prédéterminée ;
   - détection d'un objet biologique lorsqu'au moins deux capteurs alignés l'un avec l'autre selon la troisième direction ($\vec{z}$) détectent chacun simultanément un événement.

**Patentansprüche**

1. Magnetische Detektionsvorrichtung (4, 5) von mikroskopischen biologischen Objekten, umfassend:

   - einen mikrofluidischen Kanal (41), der sich zwischen einem ersten vorgeschalteten Ende (ex1) und einem zweiten nachgeschalteten Ende (ex2) erstreckt, wobei der mikrofluidische Kanal einen Einlauf, der für eine Flüssigkeit (Af) auf der Seite seines ersten nachgeschalteten Endes (ext1) geeignet ist, und einen Ausgang, der für eine Flüssigkeit (Sf) auf der Seite seines zweiten nachgeschalteten Endes (ex2) geeignet ist, aufweist, wobei der mikrofluidische Kanal (41) eine Länge in einer ersten Abflussrichtung ($\vec{x}$), eine Breite in einer zur ersten Richtung ($\vec{x}$) lotrechten zweiten Richtung ($\vec{y}$) und eine Höhe in einer zur ersten und zur zweiten Richtung ($\vec{x}$, $\vec{y}$) lotrechten dritten Richtung ($\vec{z}$) aufweist ;
   - eine Vielzahl von magnetischen Sensoren (C1, C2, .., Cn), die gegen eine Innenwand des mikrofluidischen Kanals (41) angeordnet sind; und
   - einen Dauermagneten (40), der gegen eine Außenwand des mikrofluidischen Kanals (41) derart angeordnet ist, dass die Vielzahl von magnetischen Sensoren (C1, C2, ..., Cn) in ein Magnetfeld getaucht ist, das von dem Dauermagneten (40) hergestellt ist;

wobei die Vielzahl von magnetischen Sensoren (C1, C2, ..., Cn) umfasst:

- einen ersten magnetischen Sensor (C1);
- einen zweiten magnetischen Sensor (C2) gegenüber dem ersten magnetischen Sensor (C1) derart, dass der erste und der zweite magnetischen Sensor (C1, C2) parallel zur dritten Richtung ($\vec{z}$) angeordnet sind;
- einen dritten magnetischen Sensor (C3), der derart angeordnet ist, dass der erste und der dritte magnetische Sensor (C1, C3) parallel zur ersten Richtung ($\vec{x}$) ausgerichtet sind und/oder ein vierter magnetischer Sensor (C4) derart angeordnet ist, dass der zweite und der vierte magnetische Sensor (C2, C4) parallel zur ersten Richtung ($\vec{x}$) ausgerichtet sind; wobei der dritte und der vierte magnetische Sensor (C3, C4) dem ersten und dem zweiten magnetischen Sensor (C1, C2) nachgeschaltet angeordnet sind;
- ein Datenverarbeitungssystem, das zum Bestimmen einer Geschwindigkeit eines Objekts, das ausgehend von der zwischen zwei Detektionen eines relevanten Ereignisses abgelaufenen Zeit von zwei Sensoren detektiert ist, die parallel zur ersten Richtung ($\vec{x}$) ausgerichtet sind, und zum Bestimmen einer Höhe eines Objekts, das ausgehend von dem Verhältnis der Signale detektiert ist, die von wenigstens einem gegenüber angeordneten Sensorpaar ausgegeben sind, konfiguriert ist.

2. Vorrichtung (4, 5) gemäß dem voranstehenden Anspruch, **dadurch gekennzeichnet, dass** die Vielzahl von magnetischen Sensoren (C1, C2, ..., Cn) den dritten magnetischen Sensor (C3) und den vierten magnetischen Sensor (C4) umfasst, wobei der dritte und der vierte magnetische Sensor (C3, C4) parallel zur dritten Richtung ($\vec{z}$) ausgerichtet sind.

3. Vorrichtung (4, 5) gemäß irgendeinem der voranstehenden Ansprüche, **dadurch gekennzeichnet, dass** die Vielzahl von magnetischen Sensoren (C1, C2, ..., Cn) einen fünften magnetischen Sensor (C5) umfasst, der derart angeordnet ist, dass der erste und der fünfte magnetische Sensor (C1, C5) parallel zur ersten Richtung ($\vec{x}$) ausgerichtet sind und/oder ein sechster magnetischer Sensor (C6) derart ausgerichtet ist, dass der zweite und der sechste magnetische Sensor (C2, C6) parallel zur ersten Richtung ($\vec{x}$) ausgerichtet sind; wobei der fünfte und der sechste magnetische Sensor (C5, C6) dem dritten und dem vierten magnetischen Sensor (C3, C4) nachgeschaltet ausgerichtet sind.

4. Vorrichtung (4, 5) gemäß dem voranstehenden Anspruch, **dadurch gekennzeichnet, dass** die Vielzahl von magnetischen Sensoren (C1, C2, ..., Cn) den fünften magnetischen Sensor (C5) und den sechsten magnetischen Sensor (C6) umfasst, wobei der fünfte und der sechste magnetische Sensor (C5, C6) parallel zur dritten Richtung ($\vec{x}$) ausgerichtet sind.

5. Vorrichtung (5) gemäß einem der voranstehenden Ansprüche, **dadurch gekennzeichnet, dass** die Vielzahl von magnetischen Sensoren (C1, C2, ..., Cn) umfasst:

- einen siebten magnetischen Sensor (C7), der derart angeordnet ist, dass der erste und der siebte magnetische Sensor (C1, C7) parallel zur zweiten Richtung ($\vec{y}$) ausgerichtet sind, und
- einen achten magnetischen Sensor (C8), der derart angeordnet ist, dass der zweite und der achte magnetische Sensor (C2, C8) parallel zur zweiten Richtung ($\vec{y}$) ausgerichtet sind und dass der siebte und der achte magnetische Sensor (C7, C8) parallel zur dritten Richtung ($\vec{z}$) ausgerichtet sind.

6. Vorrichtung (5) gemäß dem voranstehenden Anspruch, **dadurch gekennzeichnet, dass** die Vielzahl von magnetischen Sensoren (C1, C2, ..., Cn) umfasst:

- einen neunten magnetischen Sensor (C9), der derart angeordnet ist, dass der erste, der siebte und der neunte magnetische Sensor (C1, C7, C9) ausgerichtet sind und
- einen zehnten magnetischen Sensor (C10), der derart angeordnet ist, dass der zweite, der achte und der zehnte magnetische Sensor (C2, C8, C10) ausgerichtet sind und dass der neunte und der zehnte magnetische Sensor (C9, C10) parallel zur dritten Richtung ($\vec{z}$) ausgerichtet sind.

7. Vorrichtung (5) gemäß Anspruch 2 und irgendeinem der Ansprüche 5 oder 6, **dadurch gekennzeichnet, dass** die Vielzahl von magnetischen Sensoren (C1, C2, ..., Cn) umfasst:

- einen elften magnetischen Sensor (C11), der derart angeordnet ist, dass der dritte und der elfte magnetische Sensor (C3, C11) parallel zur zweiten Richtung ($\vec{y}$) ausgerichtet sind und
- einen zwölften magnetischen Sensor (C12), der derart angeordnet ist, dass der vierte und der zwölfte magnetische Sensor (C4, C12) parallel zur zweiten Richtung (Y) ausgerichtet sind und dass der elfte und der zwölfte magnetische Sensor (C11, C12) parallel zur dritten Richtung $(\vec{z})$ ausgerichtet sind.

8. Vorrichtung (5) gemäß dem voranstehenden Anspruch, **dadurch gekennzeichnet, dass** die Vielzahl von magnetischen Sensoren (C1, C2, ..., Cn) umfasst:

- einen dreizehnten magnetischen Sensor (C13), der derart angeordnet ist, dass der dritte, der elfte und der dreizehnte magnetische Sensor (C3, C11, C13) ausgerichtet sind, und
- einen vierzehnten magnetischen Sensor (C14), der derart angeordnet ist, dass der vierte, der zwölfte und der vierzehnte magnetische Sensor (C4, C12, C14) ausgerichtet sind und dass der dreizehnte und der vierzehnte magnetische Sensor (C13, C14) parallel zur dritten Richtung $(\vec{z})$ ausgerichtet sind.

9. Vorrichtung (5) gemäß Anspruch 4 und irgendeinem der Ansprüche 5 bis 8, **dadurch gekennzeichnet, dass** die Vielzahl von magnetischen Sensoren (C1, C2, ..., Cn) umfasst:

- einen fünfzehnten magnetischen Sensor (C15), der derart angeordnet ist, dass der fünfte und der fünfzehnte magnetische Sensor (C5, C15) parallel zur zweiten Richtung $(\vec{y})$ ausgerichtet sind, und
- einen sechzehnten magnetischen Sensor (C16), der derart angeordnet ist, dass der sechste und der sechzehnte magnetische Sensor (C6, C16) parallel zur zweiten Richtung $(\vec{y})$ ausgerichtet sind und dass der fünfzehnte und der sechszehnte magnetische Sensor (C15, C16) parallel zur dritten Richtung $(\vec{z})$ ausgerichtet sind.

10. Vorrichtung (5) gemäß dem voranstehenden Anspruch, **dadurch gekennzeichnet, dass** die Vielzahl von magnetischen Sensoren (C1, C2, ..., Cn) umfasst:

- einen siebzehnten magnetischen Sensor (C17), der derart angeordnet ist, dass de fünfte, der fünfzehnte und der siebzehnte magnetische Sensor (C5, C15, C17) ausgerichtet sind, und
- einen achtzehnten magnetischen Sensor (C18), der derart angeordnet ist, dass der sechste, der sechzehnte und der achtzehnte magnetische Sensor (C6, C16, C18) ausgerichtet sind und dass der siebzehnte und der achtzehnte magnetische Sensor (C17, C18) parallel zur dritten Richtung $(\vec{z})$ ausgerichtet sind.

11. Magnetisches Detektionsverfahren mikroskopischer biologischer Objekte mittels einer Vorrichtung (4, 5) gemäß irgendeinem der voranstehenden Ansprüche, wobei das Verfahren die folgenden Schritte umfasst:

- Detektion eines Ereignisses durch einen bestimmten magnetischen Sensor, wenn der genannte magnetische Sensor eine höhere Messung als einen vorbestimmten Grenzwert realisiert;
- Detektion eines relevanten Ereignisses, wenn wenigstens zwei gemäß der ersten Richtung $(\vec{x})$ voneinander beabstandeten Sensoren jeweils ein Ereignis in einem vorbestimmten Zeitfenster detektieren;
- Detektion eines biologischen Objekts, wenn wenigstens zwei zueinander gemäß der dritten Richtung $(\vec{z})$ ausgerichteten Sensoren jeweils gleichzeitig ein Ereignis detektieren.

**Claims**

1. Device (4, 5) for magnetically detecting microscopic biological objects comprising:

- a microfluidic channel (41) extending between a first upstream end (ex1) and a second downstream end (ex2), the microfluidic channel having an inlet suited for a fluid (Af) on the side of its first upstream end (ex1) and an outlet suited for a fluid (Sf) on the side of its second downstream end (ex2), the microfluidic channel (41) having a length in a first direction $(\vec{x})$ of flow, a width in a second direction $(\vec{y})$ perpendicular to the first direction $(\vec{x})$ and a height in a third direction $(\vec{z})$ perpendicular to the first and second directions $(\vec{x}, \vec{y})$;
- a plurality of magnetic sensors (C1, C2, ..., Cn) arranged against an inner wall of the microfluidic channel (41); and
- a permanent magnet (40) arranged against an outer wall of the microfluidic channel (41), in such a way that the plurality of magnetic sensors (C1, C2, ..., Cn) is immersed in a magnetic field created by the permanent magnet (40);

the plurality of magnetic sensors (C1, C2, ..., Cn) comprises:

- a first magnetic sensor (C1);
- a second magnetic sensor (C2) opposite the first magnetic sensor (C1) in such a way that the first and second magnetic sensors (C1, C2) are aligned parallel to the third direction $(\vec{z})$;
- a third magnetic sensor (C3) arranged in such a way that the first and third magnetic sensors (C1, C3) are aligned parallel to the first direction $\vec{x}$ and/or a fourth magnetic sensor (C4) arranged in such a way that the second and fourth magnetic sensors (C2, C4) are aligned parallel to the first direction $\vec{x}$; the third and fourth magnetic sensors (C3, C4) being arranged downstream of the first and second magnetic sensors (C1, C2);
- a data processing system configured to determine a velocity of an object detected from the time elapsed between two detections of a relevant event by two sensors aligned parallel to the first direction $\vec{x}$ and to determine a height of an object detected from the ratio of the signals emitted by at least one pair of opposite sensors.

2.  Device (4, 5) according to the preceding claim **characterised in that** the plurality of magnetic sensors (C1, C2, ..., Cn) comprises the third magnetic sensor (C3) and the fourth magnetic sensor (C4), the third and fourth magnetic sensors (C3, C4) being aligned parallel to the third direction $\vec{z}$.

3.  Device (4, 5) according to any one of the preceding claims **characterised in that** the plurality of magnetic sensors (C1, C2, ..., Cn) comprises a fifth magnetic sensor (C5) arranged in such a way that the first and fifth magnetic sensors (C1, C5) are aligned parallel to the first direction $\vec{x}$ and/or a sixth magnetic sensor (C6) arranged in such a way that the second and sixth magnetic sensors (C2, C6) are aligned parallel to the first direction $\vec{x}$; the fifth and sixth magnetic sensors (C5, C6) being arranged downstream of the third and fourth magnetic sensors (C3, C4).

4.  Device (4, 5) according to the preceding claim **characterised in that** the plurality of magnetic sensors (C1, C2, ..., Cn) comprises the fifth magnetic sensor (C5) and the sixth magnetic sensor (C6), the fifth and sixth magnetic sensors (C5, C6) being aligned parallel to the third direction $\vec{z}$.

5.  Device (5) according to any one of the preceding claims **characterised in that** the plurality of magnetic sensors (C1, C2, ..., Cn) comprises:

    - a seventh magnetic sensor (C7) arranged in such a way that the first and seventh magnetic sensors (C1, C7) are aligned parallel to the second direction $\vec{y}$, and
    - an eighth magnetic sensor (C8) arranged in such a way that the second and eighth magnetic sensors (C2, C8) are aligned parallel to the second direction $\vec{y}$ and that the seventh and eighth magnetic sensors (C7, C8) are aligned parallel to the third direction $\vec{z}$.

6.  Device (5) according to the preceding claim **characterised in that** the plurality of magnetic sensors (C1, C2, ..., Cn) comprises:

    - a ninth magnetic sensor (C9) arranged in such a way that the first, seventh and ninth magnetic sensors (C1, C7, C9) are aligned, and
    - a tenth magnetic sensor (C10) arranged in such a way that the second, eighth and tenth magnetic sensors (C2, C8, C10) are aligned and that the ninth and tenth magnetic sensors (C9, C10) are aligned parallel to the third direction $\vec{z}$.

7.  Device (5) according to claim 2 and any one of claims 5 or 6 **characterised in that** the plurality of magnetic sensors (C1, C2, ..., Cn) comprises:

    - an eleventh magnetic sensor (C11) arranged in such a way that the third and eleventh magnetic sensors (C3, C11) are aligned parallel to the second direction $\vec{y}$, and
    - a twelfth magnetic sensor (C12) arranged in such a way that the fourth and twelfth magnetic sensors (C4, C12) are aligned parallel to the second direction (Y) and that the eleventh and twelfth magnetic sensors (C11, C12) are aligned parallel to the third direction $\vec{z}$.

8.  Device (5) according to the preceding claim **characterised in that** the plurality of magnetic sensors (C1, C2, ..., Cn) comprises:

    - a thirteenth magnetic sensor (C13) arranged in such a way that the third, eleventh and thirteenth magnetic sensors (C3, C11, C13) are aligned, and
    - a fourteenth magnetic sensor (C14) arranged in such a way that the fourth, twelfth and fourteenth magnetic sensors (C4, C12, C14) are aligned and that the thirteenth and fourteenth magnetic sensors (C13, C14) are aligned parallel to the third direction $\vec{z}$.

9.  Device (5) according to claim 4 and any one of claims 5 to 8 **characterised in that** the plurality of magnetic sensors (C1, C2, ..., Cn) comprises:

    - a fifteenth magnetic sensor (C15) arranged in such a way that the fifth and fifteenth magnetic sensors (C5, C15) are aligned parallel to the second direction $\vec{y}$, and
    - a sixteenth magnetic sensor (C16) arranged in such a way that the sixth and sixteenth magnetic sensors (C6, C16) are aligned parallel to the second direction $\vec{y}$ and that the fifteenth and sixteenth magnetic sensors (C15, C16) are aligned parallel to the third direction $\vec{z}$.

**10.** Device (5) according to the preceding claim **characterised in that** the plurality of magnetic sensors (C1, C2, ..., Cn) comprises:

- a seventeenth magnetic sensor (C17) arranged in such a way that the fifth, fifteenth and seventeenth magnetic sensors (C5, C15, C17) are aligned, and
- an eighteenth magnetic sensor (C18) arranged in such a way that the sixth, sixteenth and eighteenth magnetic sensors (C6, C16, C18) are aligned and that the seventeenth and eighteenth magnetic sensors (C17, C18) are aligned parallel to the third direction ($\vec{z}$).

**11.** Method for magnetically detecting microscopic biological objects by means of a device (4, 5) according to any one of the preceding claims, the method comprising the following steps:

- detection of an event by a given magnetic sensor when said magnetic sensor carries out a measurement above a predetermined threshold;
- detection of a relevant event when at least two sensors spaced apart from each other along the first direction ($\vec{x}$) each detect an event in a predetermined temporal window;
- detection of a biological object when at least two sensors aligned with each other along the third direction ($\vec{z}$) each detect simultaneously an event.

Fig. 1a – Art antérieur

Fig. 1b – Art antérieur

Fig. 2

Fig. 3

**Fig. 4a**

**Fig. 4b**

Fig. 5a

Fig. 5b

Fig. 6

C1, ..., Cn

131

Ds

$\vec{y}$

$\vec{z}$ $\vec{x}$

**Fig. 7**

41

C2 C4 C6

C1 C3 C5

40

**Fig. 8**

Fig. 9a

Fig. 9b

Fig. 10a

Fig. 10b

Fig. 10c

Fig. 10d